# NOUVEAU FASCICULE DE BREVET EUROPEEN

(11) **EP 2 589 568 B2**
(45) Date de publication et mention de la décision concernant l'opposition: **22.09.2021**
(45) Mention de la délivrance du brevet: 15.02.2017
(21) Numéro de dépôt: 12190569.9
(22) Date de dépôt: 30.10.2012
(51) Int. Cl.: B81B 3/00, B81C 99/00, G04B 17/06, G04D 3/00, G04B 15/14

(54) **Pièce de micromécanique permettant une décharge électrique**
Verbessertes mikromechanisches Bauteil das eine elektrische Entladung ermöglicht
Improved micromechanical part allowing an electric discharge

(30) Priorité: 03.11.2011 CH 17652011
(43) Date de publication de la demande: 08.05.2013
(73) Titulaire: Sigatec SA, 1950 Sion (CH)
(72) Inventeur: Glassey, Marc-André, 1967 Bramois (CH); Gygax, Pierre, 2016 Cortaillod (CH)
(74) Mandataire: BOVARD AG

(56) Documents cités:
- EP-A1- 0 732 635
- EP-A1- 1 837 721
- EP-A1- 2 236 455
- WO-A1-2010/142602
- CH-A2- 699 780
- CH-A2- 701 266
- DE-A1- 10 155 930
- US-A- 6 080 445
- US-B1- 6 615 496

## Description

### Domaine technique

Cette demande se rapporte à une pièce de micromécanique, notamment pour l'horlogerie, comprenant une âme au moins partiellement en un matériau semi-conducteur électrique et un revêtement sur la surface de l'âme en un matériau isolant électrique.

### Etat de la technique

De telles pièces de micromécanique sont déjà connues. Par exemple, la demande de brevet européen EP-A-2 215 531 montre un ressort spiral qui est fabriqué en silicium monocristallin avec la découpe cristallographique {1,1,1} et qui est par la suite revêtu d'une couche en oxyde de silicium pour obtenir une compensation thermique de l'ensemble balancier-spiral. En outre, le document EP-A-0 732 635 propose également de réaliser une pièce de micromécanique, p.ex. pour un mouvement horloger, en un premier matériau et de la revêtir par la suite par un deuxième matériau.

L'utilisation du silicium pour la réalisation des pièces de micromécaniques liées aux mouvements horlogères fait donc aujourd'hui partie des technologies standard.

Les pièces fabriquées en silicium (ou un autre matériau similaire) offrent plusieurs avantages par rapport aux pièces horlogères classiques qui sont typiquement fabriquées en un matériau métallique, tel que fer, laiton, cuivre, ou autre. Parmi ces avantages, on peut citer notamment une fabrication simplifiée des grandes séries ainsi que la possibilité de réaliser les pièces avec des structures très spécifiques. Egalement, la qualité des états de surface et de la précision de ces pièces est nettement supérieure comparée avec les pièces qui sont fabriquées de manière classique.

L'autre grand avantage de ce type de pièces de micromécanique est la possibilité de les revêtir des différents matériaux afin d'améliorer les propriétés tribologiques (comme p.ex. dans le document précité EP-A-0 732 635) ou pour réaliser la compensation thermique (cf. le document EP-A-2 215 531). Dans ce sens, il est notamment possible d'utiliser un revêtement en oxyde de silicium et/ou en diamant de façon à réduire ou même complètement éliminer la nécessité de lubrifier les pièces.

Habituellement, les couches recouvrant le silicium sont en matériau isolant électrique. Les isolants électriques sont des matériaux qui n'ont pas (ou qui n'ont que très peu) de charges libres parce que la plupart des charges électriques sont fermement piégées dans le matériau. Par conséquent, un matériau isolant qui est soumis à l'action d'un champ électromagnétique ne conduira pas d'électricité, contrairement à un matériau conducteur.

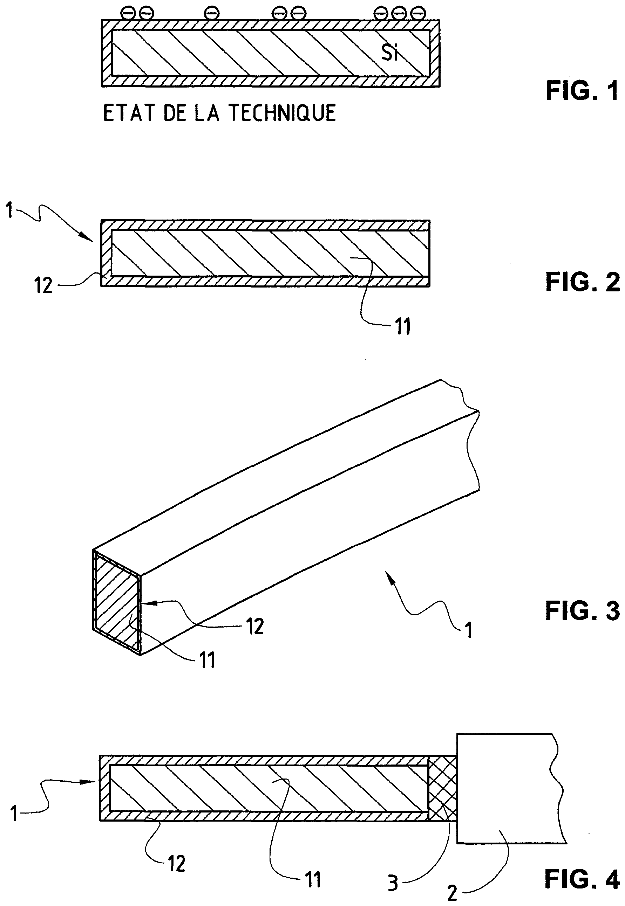

Grâce à ce fait, les matériaux isolants se chargent d'électricité statique de manière spontanée et ne s'en libèrent que difficilement. Cet effet est schématiquement représenté dans la figure 1 qui illustre une pièce de micromécanique de l'état de la technique avec quelques charges électriques reparties sur la surface de la pièce. Dans la pièce qui est illustrée dans la figure 1, l'âme de la pièce est fabriquée en silicium et recouverte d'un revêtement en oxyde de silicium. Cependant, le même effet électrostatique se produit avec tout autre revêtement en un matériau isolant.

La présence d'électricité statique sur la surface des pièces crée des forces entre les pièces qui empêchent un fonctionnement optimal de la montre. En outre, les charges électrostatiques sur la surface de la pièce attirent les particules de poussière qui peuvent dégrader le fonctionnement des pièces. Finalement, une grande accumulation des charges peut provoquer des décharges (étincelles) violentes qui peuvent même résulter en une détérioration physique des pièces.

Dans la demande de brevet suisse CH 699 780, il est décrit un ressort spiral dont un barreau de silicium est revêtu au moins partiellement par une couche d'oxyde n'ayant pas le même coefficient thermique du module de Young que ce barreau de silicium, afin que la constante du couple de rappel du ressort spiral possède une stabilité thermique améliorée.

Dans la demande de brevet suisse CH 701 266 et dans le document US 2010/0308010, il est décrit un procédé de fabrication d'un pièce de micromécanique composite qui comporte une partie métallique et une partie en silicium partiellement revêtu d'une couche en oxyde de silicium. Dans ce procédé, la partie métallique est réalisée par électrodéposition sur la couche en oxyde de silicium et sur une zone où la partie en silicium est dépourvue de cette couche.

Dans le brevet suisse CH 700 032 B1, deux spiraux superposés fabriqués en silicium sont fixés sur un axe de balancier et, afin de par le biais d'une colle.

### Exposé sommaire de l'invention

La présente invention a donc pour objet qu'une pièce de micromécanique ne présente pas ces désavantages de pièces connues, en étant en outre particulièrement convenable pour être utilisée dans le domaine d'horlogerie. De manière spécifique, l'objet de la présente invention est de permettre une décharge facile des charges électrostatiques de la surface d'une pièce de micromécanique.

A cet effet, l'invention a pour objet selon un premier aspect un sous-ensemble de micromécanique, notamment pour l'horlogerie, selon la revendication 1.

Par rapport au ressort spiral décrit dans la demande de brevet suisse CH 699 780 susmentionnée, le sous-ensemble de micromécanique selon l'invention se caractérise en ce que le corps et l'âme ont été connectés électriquement entre eux, là où la surface de cette âme est libérée du revêtement, de façon à permettre une décharge électrique entre l'âme et le corps. Le matériau semi-conducteur de l'âme est de préférence de conductivité électrique élevée.

L'avantage de cette invention réside particulièrement dans le fait que l'âme de la pièce est utilisée pour la décharge électrique. Grâce à une conductivité électrique élevée de l'âme, les charges électriques de la surface peuvent traverser le revêtement pour atteindre le matériau semi-conducteur. Comme au moins une partie de la surface de l'âme dans la pièce selon la présente invention n'est pas recouverte du revêtement isolateur, les charges électriques peuvent traverser l'âme pour se décharger vers le corps. De cette manière, tous les problèmes liés à l'électricité statique sur la surface des pièces sont éliminés d'une manière efficace.

Dans l'invention, la conductivité électrique du matériau semi-conducteur de l'âme est augmentée par un dopage et/ou par une implantation ionique. Le dopage d'un matériau semi-conducteur (tel que silicium) est la technique qui permet d'ajouter des impuretés en petites quantités au semi-conducteur afin de modifier ses propriétés concernant la conductivité électrique. Typiquement, le dopage est réalisé dans un four par diffusion à partir d'un gaz vecteur. L'implantation ionique est une autre variante de la technique de dopage et elle consiste notamment à accélérer des impuretés ionisées avec un champ électrique, afin de leur conférer l'énergie nécessaire pour rentrer dans le matériau à doper.

Ceci a notamment l'avantage qu'un matériau fabriqué à l'aide des techniques connues peut être utilisé pour obtenir les résultats souhaités. De même, un matériau semi-conducteur dopé est généralement stable dans le temps et ne perd donc pas ses propriétés de conductivité.

De manière notable, l'âme peut comprendre au moins une couche intérieure et une couche extérieure en contact avec le revêtement, la conductivité électrique de la couche extérieure étant plus élevée que la conductivité électrique de la couche intérieure. L'avantage de ce mode de réalisation de l'invention, parmi d'autres choses, réside dans le fait que juste la partie extérieure de l'âme de la pièce doit être soumise à un traitement afin d'augmenter sa conductivité électrique. Comme c'est cette partie extérieure de l'âme qui reste en contact avec le revêtement extérieur, les charges électriques peuvent néanmoins traverser l'âme pour être déchargées par le corps.

Selon un autre mode de la réalisation de la présente invention, un deuxième revêtement en un matériau conducteur électrique est prévu entre la surface de l'âme et le revêtement en un matériau isolant électrique. En particulier, ce deuxième revêtement peut être composé d'un matériau métallique, tel que chrome, vanadium ou titane. Bien sûr, d'autres métaux ou alliages de métaux sont également possibles. Cet autre mode de réalisation de la présente invention a l'avantage, parmi d'autres choses, que la fabrication d'une telle pièce peut être simplifiée. Concrètement, l'âme de la pièce peut être gravée dans une plaque du silicium selon les procédés connus, pour être revêtue d'une couche en métal par un procédé approprié. A la fin, un revêtement final en un matériau isolant peut être déposé sur la couche métallique.

De manière notable, l'âme de la pièce est au moins partiellement composée de silicium. Les avantages du silicium sont déjà mentionnés, mais on peut rappeler qu'il est très avantageux pour la production des pièces horlogères grâce à ses propriétés mécaniques, physiques et tribologiques. Egalement, le revêtement des pièces peut notablement être composé de diamant et/ou d'oxyde de silicium qui ont également de très bonnes propriétés thermiques et tribologiques.

Dans l'invention, un élément connecteur est prévu entre l'âme et le corps. L'avantage de ceci est de favoriser la décharge. Typiquement, la pièce peut être reliée au mouvement horloger et ainsi à la masse.

L'élément connecteur est une colle conductrice électrique. En particulier, une colle conductrice permet d'utiliser un seul moyen pour réaliser à la fois une connexion mécanique et une connexion électrique entre la pièce et le corps. Comme toutes les pièces dans un mouvement horloger sont reliées entre elles, l'utilisation d'une colle conductrice pour la fixation des pièces garantit qu'aucune mesure supplémentaire n'est nécessaire pour permettre la décharge de la pièce.

La pièce de micromécanique dans le sous-ensemble selon la présente invention peut notamment être un spiral horloger, destiné à être utilisé avec un balancier dans un ensemble balancier-spiral dans un mouvement horloger. Un fonctionnement propre de l'ensemble balancier-spiral est essentiel pour une bonne précision de la montre. Une élimination complète des problèmes liés à l'électricité statique est donc particulièrement importante pour un spiral horloger. Néanmoins, d'autres pièces de micromécanique, typiques d'un mouvement mécanique, peuvent aussi bénéficier de ce système de décharge par l'âme. Parmi les pièces susceptibles d'en profiter, on peut notamment citer l'ancre et la roue d'échappement, ainsi que des roues d'entrainement.

De manière notable, dans une pièce de micromécanique selon un mode de réalisation de la présente invention, l'électricité statique déchargée par l'âme peut être acheminée sur un élément voisin de la chaine cinématique par une couche conductrice. En particulier, ceci pourrait p.ex. s'appliquer à un mobile dans le rouage de finissage qui décharge l'électricité statique par l'âme sur l'axe et la transmet par la suite sur le mobile suivant. L'avantage de ce mode de réalisation réside notamment dans le fait que toute pièce dans un mouvement mécanique peut être déchargée, même si elle n'est pas en contact direct avec le châssis et/ou le boitier de la montre.

A cet endroit, nous aimerions mentionner que la présente invention se rapporte également à un procédé selon la revendication 9.

L'avantage de cet autre aspect de la présente invention réside particulièrement dans le fait que la pièce peut être fabriquée d'une manière simple et économique. Les procédés classiques et bien connus peuvent être utilisés, p.ex. la gravure ionique réactive profonde dans une plaque de silicium afin de réaliser l'âme et la déposition d'oxyde de silicium par oxydation thermique, par un dépôt chimique en phase vapeur assisté par du plasma (PECVD) ou déposition du diamant afin de réaliser le revêtement de la surface.

### Brève description des dessins

L'invention sera bien comprise à la lecture de la description ci-après faite à titre d'exemple non limitatif, en regardant les dessins ci-annexés qui représentent schématiquement :
- figure 1, une vue de coupe d'une pièce de micromécanique selon une solution connue de l'état de la technique ;
- figure 2, une vue de coupe d'une pièce de micromécanique selon un premier mode de réalisation de la présente invention ;
- figure 3, une vue en perspective de la pièce de micromécanique selon le premier mode de réalisation de la présente invention, tel que représenté dans la figure 2 ;
- figure 4, une vue de coupe d'une pièce de micromécanique selon un deuxième mode de réalisation de la présente invention ;
- figure 5, une vue de coupe d'une pièce de micromécanique selon un troisième mode de réalisation de la présente invention ; et
- figure 6, une vue de coupe d'une pièce de micromécanique selon un quatrième mode de réalisation de la présente invention.

### Description détaillée de l'invention

La description suivante, en se reportant aux dessins, explique plus en détail quelques modes de réalisation non limitatifs d'une pièce de micromécanique et de son procédé de fabrication selon la présente invention.

Les mêmes numéros de référence dans les différentes figures indiquent les mêmes éléments, sauf si le contraire est explicitement mentionné.

Figure 1 illustre une vue de coupe d'une pièce de micromécanique connue de l'état de la technique. Cette pièce comporte une âme (partie principale) en silicium Si dont toute la surface est revêtue d'une couche de diamant, oxyde de silicium ou un autre matériau isolant. Au lieu de silicium, l'âme de la pièce peut également être réalisée en un autre matériau isolant ou même être créée par une combinaison des matériaux. L'âme de la pièce est typiquement obtenue par gravure ionique réactive profonde, même si d'autres procédés de fabrication peuvent être utilisés.

Comme déjà mentionné, les isolants électriques (tels que le diamant ou l'oxyde de silicium) sont des matériaux qui ont peu de charges libres et ils se chargent donc d'électricité statique de manière spontanée. Dans la figure 1, les charges accumulées sur la surface de la pièce sont schématiquement illustrées par des petits ronds symbolisant les électrons. Cette électricité statique sur des pièces a des effets très désavantageux sur leurs performances.

Pour palier à ces inconvénients des pièces de micromécanique actuelles, la présente invention utilise par exemple une pièce de micromécanique telle que représentée dans la figure 2. La pièce 1 comporte également une âme 11 et un revêtement 12 sur la surface de l'âme 11. L'âme 11 est réalisée en un matériau semi-conducteur, tel que silicium monocristallin ou polycristallin. Bien entendu, d'autres matériaux avec les propriétés de semi-conducteurs sont tout à fait possibles. L'âme 11 peut être gravée dans une plaque de matériau semi-conducteur à l'aide des procédés connus, tels que gravure ionique réactive profonde. D'autres procédés peuvent évidemment être appliqués. La surface de l'âme 11 de la pièce 1 est revêtue d'une couche d'un matériau isolant électrique 12, tel que l'oxyde de silicium (SiO₂) ou le diamant. De nouveau, d'autres matériaux isolants peuvent être utilisés.

Contrairement à une pièce connue de l'état de la technique, l'âme 11 de la pièce de micromécanique 1 selon la présente invention est réalisée en un matériau semi-conducteur ayant une conductivité électrique élevée. La conductivité électrique améliorée du matériau semi-conducteur peut être atteinte grâce à des différents moyens, illustrés plus en détail ultérieurement. Une partie de la surface de l'âme 11 de la pièce de micromécanique 1 dans la figure 2 (la partie à droite de la figure) est libérée du revêtement 12. La figure 3 explique la pièce 1 dans une vue en perspective. Dans cette figure 3, on retrouve l'âme 11 de la pièce 1 et son revêtement 12. Il est facilement visible qu'une partie de l'âme 11 n'est pas recouverte de la couche 12. Par ce fait, il est possible de réaliser une connexion mécanique et électrique entre l'âme 11 et un corps extérieur.

Typiquement, une pièce de micromécanique 1 telle que représentée dans la figure 3 peut être un spiral horloger, destiné à être utilisé dans un mouvement horloger avec un balancier pour réaliser l'ensemble balancier-spiral qui détermine la marche de la montre. L'âme 11 du spiral 1 peut donc être ouverte (non recouverte du revêtement 12) à son bout extérieur qui sert notamment de connexion du spiral à l'élément appelé « coq ». De cette façon, l'âme 11 du spiral 1 est reliée au mouvement et permet ainsi un dégagement simple des charges électriques statiques de la surface du spiral 1. Bien entendu, l'exemple des spiraux horlogers n'est aucunement limitatif et il est évident que d'autres pièces horlogères ou non-horlogères peuvent être réalisées de la même manière.

Grâce à une conductivité électrique élevée de l'âme 11 et le manque de revêtement 12 sur une certaine partie de la surface de l'âme 11, les charges électriques qui s'accumulent sur la surface de la pièce 1 peuvent facilement traverser le revêtement 12 et se décharger à travers l'âme 11 et le corps extérieur. De cette façon, l'évacuation de l'électricité statique est directe et facile.

Afin d'obtenir une conductivité électrique améliorée dans l'âme 11, il est procédé à un dopage et/ou une implantation ionique du matériau semi-conducteur. Le dopage des semi-conducteurs permet concrètement d'ajouter des impuretés en petites quantités avec le but de modifier la conductivité électrique. Essentiellement, un matériau semi-conducteur ne conduit pas d'électricité. En effet, toutes les charges électriques dans un semi-conducteur sont typiquement engagées dans les liaisons covalentes et n'arrivent pas à atteindre l'énergie qui est nécessaire afin de passer dans l'état libre. Par le dopage, les atomes d'un autre matériau sont introduits dans la matrice du matériau semi-conducteur. Ces atomes, ayant un surplus ou un déficit d'électrons créent un déséquilibre énergétique qui rend le semi-conducteur capable de conduction électrique.

Il existe essentiellement deux types de dopage, à savoir le dopage de type N, qui consiste à produire un excès d'électrons, qui sont négativement chargés (d'où le nom), ainsi que le dopage de type P, qui consiste à produire une carence en électrons, donc un excès de trous, considérés comme positivement chargés.

Différentes techniques industrielles de dopage sont connues et utilisées à ce jour, notamment le dopage par diffusion (où les atomes des impuretés sont diffusés dans le semi-conducteur à partir d'un gaz vecteur), le dopage par transmutation nucléaire (où les atomes de silicium sont transformés par le procédé d'absorption de neutrons en un atome de phosphore) ou bien le dopage par implantation ionique (où les atomes des impuretés sont accélérés pour s'écraser contre le semi-conducteur et pour le pénétrer grâce à un champ magnétique). Bien entendu, la quantité des impuretés (et donc le niveau de dopage du semi-conducteur) peut être variée en fonction des besoins concrets. Un haut dopage est avantageux pour favoriser la décharge de l'électricité statique, mais le niveau de dopage peut aussi être baissé dans certaines situations qui requièrent une conductivité moins prononcée.

La pièce de micromécanique 1 dans la figure 4 illustre un mode de réalisation de la présente invention. Cette pièce 1 comprend une âme 11 en un matériau semi-conducteur (p.ex. silicium) et un revêtement 12 sur une partie de la surface de l'âme 11. En outre, la pièce 1 est reliée à un corps extérieur 2 (p.ex. le « coq » du pont de balancier comme mentionné plus haut) par un élément connecteur 3. Cet élément connecteur 3 sert à assurer à la fois une liaison mécanique entre la pièce 1 et le corps extérieur 2 et une liaison électrique qui permet la décharge de l'électricité statique.

La figure 4 peut aussi représenter la coupe d'une ancre ou d'une roue d'échappement où la position 2 représente l'axe.

L'élément connecteur 3 est une colle conductrice électrique. Ce type de colles (également nommées 'ECA' qui est un acronyme de l'anglais « Electrically Conductive Adhesive ») possède à la fois la propriété de fixation mécanique (comme toutes les colles standard), mais permet également un transfert des charges électriques. Parmi les plus utilisées, on trouve à ce jour les polymères conducteurs électriques ou polymères conducteurs intrinsèques (PCI).

D'autres éléments connecteurs 3, ne faisant pas partie de l'invention, sont également possibles pour assurer une connexion électrique entre la pièce 1 et le corps extérieur 2, y compris notamment des éléments qui assurent la liaison entre la pièce 1 et le corps extérieur 2 de manière purement mécanique (p.ex. une liaison par brasage, rivetage, soudage, etc.). De même, il est aussi imaginable dans des exemples ne faisant pas partie de l'invention, d'obtenir la liaison électrique entre la pièce de micromécanique 1 et le corps extérieur 2 par un contact direct entre la partie de l'âme 11 libérée du revêtement 12 et un segment approprié du corps 2. De préférence, une telle connexion devrait être protégée par un moyen approprié pour empêcher une oxydation non souhaitée du matériau semi-conducteur (p.ex. silicium). Une protection de la partie non-revêtue de l'âme 11 est importante de manière générale afin d'éviter la composition d'une couche d'oxyde natif qui rendrait difficile (ou même empêcherait complètement) le passage des charges électriques.

Selon un exemple hors de l'invention, la pièce 1 peut aussi être reliée de manière électrique à un corps extérieur afin de permettre la décharge de l'électricité statique par un contact passager entre une partie libérée de l'âme 11 et une surface appropriée d'un corps extérieur 2. Typiquement, une telle connexion électrique transitoire pourrait être réalisée entre les palettes d'une ancre et les dents de la roue correspondante. Dans ce sens, la décharge électrique de l'ancre pourrait se produire lors de chaque nouveau contact avec la roue d'échappement.

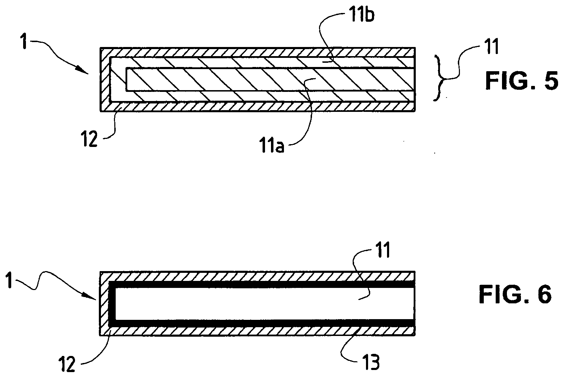

Les figures 5 et 6 montrent deux autres modes de réalisation de cette invention. Concrètement, la pièce de micromécanique 1 dans la figure 5 a une âme 11 qui comprend une couche intérieure 11a et une couche extérieure 11b, avec les conductivités électriques différentes. En particulier, les matériaux pour ces deux couches 11a, 11b peuvent être choisis de façon à ce que la conductivité électrique de la couche extérieure 11b soit plus élevée que la conductivité électrique de la couche intérieure 11b. Cet effet peut p.ex. être obtenu par des dopages différents des différentes couches du silicium ou par la création d'une structure sandwich à partir de deux plaques de silicium avec les propriétés conductrices différentes.

D'un autre côté, dans la figure 6, un deuxième revêtement 13 en un matériau conducteur électrique est prévu entre la surface de l'âme 11 et le premier revêtement 12 du matériau isolant électrique. Ce deuxième revêtement 13 peut surtout être composé d'un matériau métallique, tel que chrome ou titane, mais il est tout à fait possible de réaliser ce deuxième revêtement 13 en un non-métal. Dans ce cas, il est bien entendu très important de choisir les matériaux pour les premier 12 et deuxième 13 revêtement de façon à obtenir une bonne adhérence des matériaux. Notamment, un revêtement 12 extérieur en diamant est très adapté à être utilisé avec une couche intermédiaire 13, étant donné qu'il a une bonne adhérence sur les surfaces métalliques.

Pour résumer, la présente invention se rapporte essentiellement à une pièce 1 de micromécanique qui comprend une âme 11 fabriquée en un matériau semi-conducteur et un revêtement 12 qui ne couvre la surface de l'âme 11 que partiellement. La partie libre de l'âme 11 est connectée électriquement à un corps extérieur pour permettre l'évacuation des charges électriques accumulées sur la surface de la pièce 1 par l'âme 11 dont la conductivité, à ce titre, a été augmentée par un dopage du matériau semi-conducteur (avec éventuellement l'application d'une couche conductrice (p.ex. métallique) entre la surface de l'âme 11 et le revêtement isolant 12).

Dans le procédé de fabrication d'une pièce de micromécanique 1 selon la présente invention, on augmente la conductivité électrique d'un matériau semiconducteur électrique par un dopage et/ou par une implantation ionique, on grave une âme 11 dans le matériau semi-conducteur électrique (p.ex. silicium). Par la suite, on dépose d'abord au moins une couche de revêtement 12 en un matériau isolant électrique sur la totalité de la surface de l'âme 11, on enlève ce revêtement 12 sur au moins une partie de la surface de l'âme 11 et on connecte électriquement le corps et l'âme, là où la surface de cette âme est libérée du revêtement, au moyen d'une colle conductrice électrique prévue entre l'âme et le corps, de façon à permettre une décharge électrique entre l'âme et le corps. Si nécessaire (comme explicité en connexion avec le mode de réalisation de l'invention dans la figure 6), un deuxième revêtement 13 en un matériau conducteur électrique peut être déposé sur l'âme 11 avant de déposer le revêtement 12 isolant.

La libération de l'âme 11 peut être atteinte à l'aide de différents moyens, notamment :
- On peut briser l'âme 11 (donc le silicium) et sa couche isolante 12 de manière mécanique. Par exemple dans le cas d'un spiral horloger, on peut imaginer briser le spiral juste après le point de pitonnage ;
- On peut briser l'âme 11 et sa couche isolante 12 par le biais d'une attache qui relie la pièce 1 au wafer. Une attache est un élément qui relie le composant (la pièce 1) au reste de la plaque du silicium dans laquelle on grave les pièces 1. Normalement, il s'agit d'une section très fine qu'on brise avant de détacher les pièces 1 du wafer. De cette manière, la séparation physique des pièces 1 du wafer favorise automatiquement l'exposition d'une partie de l'âme 11 ;
- On peut enlever la partie isolante 12 de la pièce 1 sur des pièces 1 fabriquées par un usinage mécanique (p.ex. le meulage) ; et
- On peut enlever le revêtement isolant 12 par un enlèvement chimique (p.ex. HF).

Dans ce qui précède, l'invention a été décrite d'abord en termes généraux et ensuite sous forme d'une explication de réalisations pratiques. Bien entendu, l'invention n'est pas limitée à la description de modes de mise en œuvre ; il va de soi que de nombreuses variations et modifications peuvent être apportées sans que l'étendue de l'invention qui est définie par le contenu des revendications, ne soit quittée.

## Revendications

1. Sous-ensemble de micromécanique, notamment pour l'horlogerie, comportant un corps (2) et une pièce de micromécanique (1) comprenant une âme (11) au moins partiellement en un matériau semi-conducteur électrique et un revêtement (12) en un matériau isolant électrique sur la surface de l'âme (11), une partie de la surface de l'âme (11) étant libérée du revêtement (12),
**caractérisé en ce que** le corps (2) et l'âme (11) ont été et sont connectés électriquement entre eux, là où la surface de cette âme (11) est libérée du revêtement (12), de façon à permettre une décharge électrique entre l'âme (11) et le corps (2), et **en ce qu'**une colle conductrice électrique est un élément connecteur (3) prévu entre l'âme (11) et le corps (2), la conductivité électrique du matériau semi-conducteur de l'âme (11) ayant été augmentée par un dopage et/ou par une implantation ionique.

2. Sous-ensemble de micromécanique selon la revendication 1, **caractérisé en ce que** l'âme (11) comprend au moins une couche intérieure (11a) et une couche extérieure (11b) en contact avec le revêtement (12), la conductivité électrique de la couche extérieure (11b) étant plus élevée que la conductivité électrique de la couche intérieure (11a).

3. Sous-ensemble de micromécanique selon l'une quelconque des revendications 1 à 2, **caractérisé en ce qu'**un deuxième revêtement (13) en un matériau conducteur électrique est prévu entre la surface de l'âme (11) et le revêtement (12) en un matériau isolant électrique.

4. Sous-ensemble de micromécanique selon la revendication 3, **caractérisé en ce que** le deuxième revêtement (13) est composée d'un matériau métallique, tel que chrome, vanadium ou titane.

5. Sous-ensemble de micromécanique selon l'une quelconque des revendications 1 à 4, **caractérisé en ce que** l'âme (11) est au moins partiellement composée de silicium.

6. Sous-ensemble de micromécanique selon l'une quelconque des revendications 1 à 5, **caractérisée en ce que** le revêtement (12) est composé de diamant et/ou d'oxyde de silicium.

7. Sous-ensemble de micromécanique selon l'une quelconque des revendications 1 à 6, **caractérisé en ce que** la pièce (1) est un spiral horloger, destiné à être utilisé avec un balancier dans un ensemble balancier-spiral.

8. Sous-ensemble de micromécanique selon l'une quelconque des revendications 1 à 6, **caractérisé en ce que** la pièce (1) est une ancre, une roue d'ancre ou un mobile d'engrenage.

9. Procédé de fabrication d'un sous-ensemble de micromécanique comportant un corps (2) et une pièce de micromécanique (1), le procédé comprenant les étapes :
- augmenter la conductivité électrique d'un matériau semi-conducteur électrique par un dopage et/ou par une implantation ionique,
- graver une âme (11) de la pièce de micromécanique (1) dans le matériau semi-conducteur électrique,
**caractérisé en ce que** le procédé comprend en outre les étapes suivantes :
- déposer au moins une couche de revêtement (12) en un matériau isolant électrique sur la totalité de la surface de l'âme (11),
- enlever le revêtement (12) sur une partie de la surface de l'âme (11) de façon à libérer l'âme (11), et
- connecter électriquement le corps (2) et l'âme (11), là où la surface de cette âme (11) est libérée du revêtement (12), au moyen d'une colle conductrice électrique (3) prévue entre l'âme (11) et le corps (2), de façon à permettre une décharge électrique entre l'âme (11) et le corps (2).

10. Procédé de fabrication selon la revendication 9, dans lequel un deuxième revêtement (13) en un matériau conducteur électrique est déposé sur l'âme (11) avant de déposer le revêtement (12) en un matériau isolant électrique.

11. Procédé de fabrication selon les revendications 9 ou 10, dans lequel l'âme (11) est au moins partiellement fabriquée en silicium et dans lequel la gravure de l'âme (11) est effectuée par gravure ionique réactive profonde.

12. Procédé de fabrication selon l'une quelconque des revendications 9 à 11, dans lequel le revêtement (12) est en diamant et/ou en oxyde de silicium et dans lequel le revêtement est obtenu par oxydation thermique ou par dépôt chimique en phase vapeur assisté par du plasma.

13. Procédé de fabrication selon la revendication 10, dans lequel le deuxième revêtement (13) est en métal tel que chrome, vanadium ou titane.

## Patentansprüche

1. Mikromechanisches Bauteil, insbesondere für die Uhrenherstellung, umfassend einen Körper (2) und einen mikromechanischen Abschnitt (1), umfassend einen Kern (11), gefertigt zumindest teilweise aus einem elektrischen Halbleitermaterial und eine Beschichtung (12), gefertigt aus einem elektrisch isolierenden Material, auf der Oberfläche des Kerns (11), wobei teilweise die Oberfläche des Kerns (11) von der Beschichtung (12) freigelegt ist,
**dadurch gekennzeichnet, dass** der Körper (2) und der Kern (11) miteinander elektrisch verbunden worden sind und sind, dort wo die Oberfläche des Kerns (11) von der Beschichtung (12) freigelegt ist, so dass eine elektrische Entladung zwischen dem Kern (11) und dem Körper (2) ermöglicht ist, und dass ein elektrisch leitendes Haftmittel ein Verbindungselement (3) zwischen dem Kern (11) und dem Körper (2) vorgesehen ist, wobei die elektrische Leitfähigkeit des Halbleitermaterials des Kerns (11) durch eine Dotierung und/oder durch eine Ionenimplantation erhöht worden ist.

2. Mikromechanisches Bauteil gemäss Anspruch 1, **dadurch gekennzeichnet, dass** der Kern (11) mindestens eine innere Schicht (11a) und eine äussere Schicht (11b) in Kontakt mit der Beschichtung (12) aufweist, und die elektrische Leitfähigkeit der äusseren Schicht (11b) grösser ist als die elektrische Leitfähigkeit der inneren Schicht (11a).

3. Mikromechanisches Bauteil gemäss einem der vorhergehenden Ansprüche, **dadurch gekennzeichnet, dass** eine zweite Beschichtung (13) aus einem elektrisch leitenden Material vorgesehen ist zwischen der Oberfläche des Kerns (11) und der Beschichtung (12) aus einem elektrisch isolierenden Material.

4. Mikromechanisches Bauteil gemäss Anspruch 3, **dadurch gekennzeichnet, dass** die zweite Beschichtung (13) ein metallisches Material enthält, wie Chrom, Vanadium oder Titan.

5. Mikromechanisches Bauteil gemäss einem der Ansprüche 1 bis 4, **dadurch gekennzeichnet, dass** der Kern (11) zumindest teilweise Silizium enthält.

6. Mikromechanisches Bauteil gemäss einem der Ansprüche 1 bis 5, **dadurch gekennzeichnet, dass** die Beschichtung (12) Diamant und/oder Siliziumoxid enthält.

7. Mikromechanisches Bauteil gemäss einem der Ansprüche 1 bis 6, **dadurch gekennzeichnet, dass** der Abschnitt (1) eine Uhrfeder ist, bestimmt, um mit einer Unruh in einer Unruh-Feder-Anordnung eingesetzt zu sein.

8. Mikromechanisches Bauteil gemäss einem der Ansprüche 1 bis 6, **dadurch gekennzeichnet, dass** der Abschnitt (1) ein Uhranker, ein Uhrankerrad oder ein bewegliches Übersetzungselement ist.

9. Verfahren zur Herstellung eines mikromechanischen Bauteils, umfassend einen Körper (2) und einen mikromechanischen Abschnitt (1), wobei das Verfahren die Schritte umfasst:
- Erhöhen der elektrischen Leitfähigkeit eines elektrischen Halbleitermaterials durch eine Dotierung und/oder eine Ionenimplantation,
- Ätzen eines Kerns (11) des mikromechanischen Abschnitts (1) in dem elektrischen Halbleitermaterial,
**dadurch gekennzeichnet, dass** das Verfahren des Weiteren die folgenden Schritte umfasst:
- Aufbringen auf der gesamten Oberfläche des Kerns (11) zumindest eine Beschichtung (12) aus einem elektrisch isolierenden Material,
- Entfernen der Beschichtung (12) von einem Teil der Oberfläche des Kerns (11) derart, dass der Kern (11) freiliegt, und
- Elektrisches Verbinden des Körpers (2) und des Kerns (11), dort wo die Oberfläche des Kerns (11) von der Beschichtung (12) freigelegt ist, mittels eines elektrisch leitenden Haftmittels, welches zwischen dem Kern (11) und dem Körper (2) vorgesehen ist, derart, dass eine elektrische Entladung zwischen dem Kern (11) und dem Körper (2) ermöglicht ist.

10. Verfahren zur Herstellung gemäss Anspruch 9, wobei eine zweite Beschichtung (13) aus einem elektrisch leitenden Material auf dem Kern (11) vor der Beschichtung (12) aus elektrisch isolierendem Material aufgebracht wird.

11. Verfahren zur Herstellung gemäss den Ansprüchen 9 oder 10, wobei der Kern (11) zumindest teilweise Silizium enthält und wobei das Ätzen des Kerns (11) mittels eines reaktiven lonentiefätzens erfolgt.

12. Verfahren zur Herstellung gemäss einem der Ansprüche 9 bis 11, wobei die Beschichtung (12) aus Diamant und/oder Siliziumoxid ist und wobei die Beschichtung durch thermische Oxidation oder durch Plasmagasphasenabscheidung erhalten wird.

13. Verfahren zur Herstellung gemäss Anspruch 10, wobei die zweite Beschichtung (13) aus Metall wie Chrom, Vanadium oder Titan ist.

## Claims

1. Micromechanical subassembly, in particular for watchmaking, comprising a body (2) and a micromechanical part (1) comprising a core (11) at least partially made of an electrical semiconductor material and a coating (12) made of an electrically insulating material on the surface of the core (11), part of the surface of the core (11) being freed of the coating (12),
**characterized in that** the body (2) and the core (11) have been and are electrically connected to one another, there where the surface of this core (11) is freed of the coating (12), in such a way as to permit an electrical discharge between the core (11) and the body (2), and **in that** an electrically conductive adhesive is a connector element (3) provided between the core (11) and the body (2), the electrical conductivity of the semiconductor material of the core (11) having been increased by a doping and/or by an ionic implantation.

2. Micromechanical subassembly according to claim 1, **characterized in that** the core (11) comprises at least one internal layer (11a) and one external layer (11b) in contact with the coating (12), the electrical conductivity of the external layer (11b) being greater than the electrical conductivity of the inner layer (11a).

3. Micromechanical subassembly according to any one of the claims 1 to 2, **characterized in that** a second coating (13) of an electric conductor material is provided between the surface of the core (11) and the coating (12) of an electrically insulating material.

4. Micromechanical subassembly according to claim 3, **characterized in that** the second coating (13) is composed of a metallic material, such as chromium, vanadium or titanium.

5. Micromechanical subassembly according to any one of the claims 1 to 4, **characterized in that** the core (11) is at least partially composed of silicon.

6. Micromechanical subassembly according to any one of the claims 1 to 5, **characterized in that** the coating (12) is composed of diamond and/or silicon oxide.

7. Micromechanical subassembly according to any one of the claims 1 to 6, **characterized in that** the part (1) is a horological spiral balance spring intended to be used with a balance in a balance-spiral spring assembly.

8. Micromechanical subassembly according to any one of the claims 1 to 6, **characterized in that** the part (1) is a pallet fork, a pallet wheel or a mobile gearing part.

9. Method of manufacture of a micromechanical subassembly comprising a body (2) and a micromechanical part (1), the method comprising the steps:
- increasing the electrical conductivity of an electrical semi-conductor material by a doping and/or by an ionic implantation,
- etching a core (11) of the micromechanical part (1) in the electrical semiconductor material,
**characterized in that** the method further comprises the following steps:
- depositing at least one layer of coating (12) of an electrically insulating material on the entire surface of the core (11),
- removing the coating (12) on part of the surface of the core (11) in such a way as to free the core (11), and
- electrically connecting the body (2) and the core (11), there where the surface of this core (11) is freed of the coating (12), by means of an electrically conductive adhesive provided between the core (11) and the body (2), in such a way as to permit an electrical discharge between the core (11) and the body (2).

10. Method of manufacture according to claim 9, wherein a second coating (13) of an electrically conducting material is deposited on the core (11) before depositing the coating (12) of an electrically insulating material.

11. Method of manufacture according to claims 9 or 10, wherein the core (11) is at least partially made of silicon and wherein the etching of the core (11) is carried out by deep reactive ion etching.

12. Method of manufacture according to any one of the claims 9 to 11, wherein the coating (12) is of diamond and/or of silicon oxide and wherein the coating is obtained by thermal oxidation or by plasma-enhanced chemical vapour deposition.

13. Method of manufacture according to claim 10, wherein the second coating (13) is of metal such as chromium, vanadium or titanium.
